# DEMANDE DE BREVET EUROPEEN

(11) **EP 4 084 245 A1**
(43) Date de publication de la demande: **02.11.2022**
(21) Numéro de dépôt: 22169115.7
(22) Date de dépôt: 20.04.2022
(51) Int. Cl.: H02G 1/02, B64C 29/00

(54) **DRONE AVEC SYSTÈME DE POSITIONNEMENT D'OUTIL**

(30) Priorité: 30.04.2021 CA 3116940
(71) Demandeur: HYDRO QUEBEC, Montreal, QC H2Z 1A4 (CA)
(72) Inventeur: LAVOIE, Samuel, SAINTE-JULIE, J3E 1T6 (CA)
(74) Mandataire: Plasseraud IP

(57) **Abrégé**

Un système de positionnement d'un outil d'un véhicule aérien sans équipage pouvant être monté relativement à une ligne électrique pour surveiller un composant de la ligne. Le système de positionnement comprend un module de déplacement ayant un premier membre montable à un côté d'un corps du véhicule aérien sans équipage. Un deuxième membre est déplaçable verticalement par rapport au premier membre sur le côté du corps. Un porte-outil est couplé pivotablement au deuxième membre et couplable à l'outil, le porte-outil étant déplaçable relativement au corps pour monter l'outil au composant ou autour du composant.

## Description

### RENVOI AUX DEMANDES DE BREVETS CONNEXES

Renvoi est fait à la demande de brevet internationale ayant le numéro de demande PCT/CA2017/051385 et déposée le 21 novembre 2017, à la demande de brevet internationale ayant le numéro de demande PCT/CA2017/051157 et déposée le 29 septembre 2017, et à la demande de brevet provisoire américaine ayant le numéro de demande US 62/425,235 et déposée le 22 novembre 2016, dont l'entièreté de chacune de celles-ci est incorporée dans la présente demande de brevet par référence.

### DOMAINE TECHNIQUE

La demande porte d'une façon générale sur les lignes électriques et, concerne plus particulièrement, un appareil et un procédé destinés à l'inspection des composants de celles-ci.

### CONTEXTE DE LA TECHNIQUE

Le fonctionnement de lignes électriques requiert d'inspecter ou de surveiller les composants de lignes électriques. Certaines techniques d'inspection classiques dites indirectes comprennent l'observation à l'aide d'une caméra visuelle ou infrarouge. Ces techniques peuvent s'avérer inadéquates pour déceler l'existence de dommage ou d'usure d'un composant, particulièrement à l'intérieur de celui-ci. Parmi les alternatives permettant de caractériser l'intérieur des composants, la plupart s'avèrent fastidieuses, coûteuses et/ou même destructrices, en particulier lorsqu'il s'agit d'échantillonner le composant pour analyse *ex situ.* Certaines des techniques les plus pénétrantes impliquent l'utilisation d'appareils à rayonnement électromagnétique, particulièrement encombrants.

L'utilisation d'un robot muni de l'équipement d'inspection et commandé à distance peut s'avérer avantageux pour la mise en oeuvre de certaines techniques. Qu'il s'agisse d'un robot conçu pour prendre appui et se déplacer directement sur la ligne, et/ou d'un robot de type aéroporté, l'établissement et le maintien d'une position adéquate de l'équipement d'inspection par rapport au composant visé peut être ardu ou même impossible.

### SOMMAIRE

Est dévoilé un véhicule aérien sans équipage pouvant être monté relativement à une ligne électrique pour surveiller un composant de la ligne, le véhicule comprenant: un corps ayant des côtés et un système de propulsion pour soulever, abaisser et diriger le véhicule relativement à la ligne; un système de positionnement d'outil incluant un module de déplacement ayant un premier membre monté au corps, un deuxième membre déplaçable verticalement par rapport au premier membre, et un porte-outil couplé pivotablement au deuxième membre; et un outil de surveillance montable au porte-outil pour être positionné à distance du corps sur un côté des côtés du corps et pour être déplaçable avec le porte-outil relativement au corps pour être monté au composant ou autour du composant.

Selon une réalisation, en exemple, le porte-outil est pivotable à un angle de tangage et/ou à un angle de lacet, relativement au deuxième membre.

Selon une réalisation, en exemple, le porte-outil est pivotable à l'angle de tangage, et le système de positionnement d'outil inclut un moyen d'orientation pour biaiser le porte-outil depuis l'angle de tangage vers une orientation standard du porte-outil relativement au deuxième membre.

Selon une réalisation, en exemple, le système de positionnement d'outil inclut un bras de support s'étendant longitudinalement entre une première extrémité montée au corps et une deuxième extrémité positionnée à distance du côté du corps, le premier membre du module de déplacement monté au bras de support à distance de la première extrémité sur le côté du corps.

Selon une réalisation, en exemple, le bras de support est pivotable relativement au corps afin de pivoter le module de déplacement et le porte-outil relativement au corps à un angle de lacet.

Selon une réalisation, en exemple, le système de positionnement d'outil inclut un moyen pour biaiser le bras de support depuis l'angle de lacet vers une orientation standard du bras de support.

Selon une réalisation, en exemple, le porte-outil est pivotable à un premier angle de lacet par rapport au deuxième membre selon un premier axe, le bras de support étant pivotable à un deuxième angle de lacet par rapport au corps selon un deuxième axe parallèle au premier axe.

Selon une réalisation, en exemple, l'outil de surveillance est dans une orientation standard de l'outil de surveillance lorsque le bras de support est dans l'orientation standard du bras de support et le porte-outil est dans l'orientation standard du porte-outil.

Selon une réalisation, en exemple, l'outil de surveillance s'étend en-dessous du bras de support.

Selon une réalisation, en exemple, un volume de travail non-obstrué est défini en dessous du bras de support et sur ledit côté des côtés du corps, le volume de travail non-obstrué dimensionné de sorte qu'une portion de la ligne ayant le composant puisse être reçue par le volume de travail non-obstrué, l'outil de surveillance étant déplaçable via le système de positionnement d'outil pour être monté à ou autour du composant dans le volume de travail non-obstrué.

Selon une réalisation, en exemple, une cage est montée au corps et circonscrit au moins en partie le volume de travail non-obstrué, l'outil de surveillance montable au porte-outil pour s'étendre depuis le porte-outil à l'intérieur de la cage jusqu'à l'extérieur de la cage.

Selon une réalisation, en exemple, l'outil de surveillance a un dispositif proximal et un dispositif distal positionné à distance du dispositif proximal, l'outil de surveillance étant montable au porte-outil à un endroit entre le dispositif proximal et le dispositif terminal de sorte que le dispositif proximal est plus près du corps que le dispositif distal.

Selon une réalisation, en exemple, l'outil de surveillance est ajustable en longueur de façon à faire varier une distance entre le dispositif distal et le porte-outil.

Selon une réalisation, en exemple, le module de déplacement inclut un moteur attaché au premier membre et relié au deuxième membre pour actionner le deuxième membre et dans lequel, optionnellement, le moteur est relié au deuxième membre par une bielle agencée entre le moteur et le deuxième membre ou par une noix montée sur une vis agencée au deuxième membre.

Est dévoilé une méthode de positionnement d'un véhicule aérien sans équipage relativement à un composant d'une ligne électrique, la méthode comprenant: déposer un corps du véhicule sur la ligne avec un côté du corps à distance du composant de la ligne; et déplacer un outil de surveillance du véhicule relativement au côté du corps dans une direction verticale le long du côté du corps pour monter l'outil de surveillance au composant ou autour du composant.

Selon une réalisation, en exemple, la méthode peut comprendre conformer une orientation de l'outil de surveillance relativement à une orientation du composant relativement à la ligne.

Selon une réalisation, en exemple, conformer l'orientation de l'outil de surveillance inclut déplacer l'outil de surveillance pour que l'outil de surveillance entre en contact avec le composant, permettant ainsi à l'outil de surveillance de pivoter relativement au côté du corps lorsque l'outil de surveillance entre en contact avec le composant.

Selon une réalisation, en exemple, déplacer l'outil de surveillance inclus au moins l'un de déplacer le corps le long de la ligne vers le composant pour déplacer l'outil de surveillance le long du composant et déplacer l'outil de surveillance selon la direction verticale à l'encontre du composant.

Est dévoilé un système de positionnement d'un outil d'un véhicule aérien sans équipage pouvant être monté relativement à une ligne électrique pour surveiller un composant de la ligne, le système de positionnement comprenant: un module de déplacement ayant un premier membre montable à un côté d'un corps du véhicule aérien sans équipage, un deuxième membre déplaçable verticalement par rapport au premier membre sur le côté du corps, et un porte-outil couplé pivotablement au deuxième membre et couplable à l'outil, le porte-outil étant déplaçable relativement au corps pour monter l'outil au composant ou autour du composant.

### DESCRIPTION DES DESSINS

Il est désormais fait référence aux figures d'accompagnement, dans lesquelles :
La figure 1 est une vue en perspective d'un véhicule aérien sans équipage, le véhicule monté sur une ligne électrique à proximité d'un composant de la ligne;
La figure 2A est une vue en coupe transversale latérale d'une portion de la ligne électrique de la figure 1 incluant le composant de la figure 1;
La figure 2B est une vue en coupe transversale latérale d'une portion de la ligne électrique de la figure 1 avec une composante;
La figure 3 est une vue en perspective agrandie d'un outil de surveillance du véhicule de la figure 1, montré en contact avec la portion de la ligne électrique de la figure 2A;
La figure 4 est une vue latérale du véhicule aérien sans équipage de la figure 1, montrant une portée de déplacement vertical d'un système de positionnement d'outil du véhicule;
La figure 5A est une vue en perspective du système de positionnement d'outil du véhicule de la figure 4, un porte-outil du système de positionnement d'outil étant représenté dans une première position verticale;
La figure 5B est une vue en perspective du système de positionnement d'outil du véhicule de la figure 4, le porte-outil du système de positionnement d'outil étant représenté dans une deuxième position verticale;
La figure 6 est une vue en perspective d'un autre véhicule aérien sans équipage;
La figure 6A est une autre vue en perspective d'une portion du véhicule aérien de la figure 6;
La figure 7A est une vue de dessus du véhicule de la figure 6, montrant un porte-outil et un bras de support d'un système de positionnement d'outil du véhicule respectivement pivotés à un premier angle et à un deuxième angle respectivement à un corps du véhicule;
La figure 7B est une vue de dessus du véhicule de la figure 6, montrant le porte-outil et le bras de support respectivement pivotés par rapport au corps du véhicule; et
La figure 8 est une représentation schématique d'une chaîne cinématique d'un système de positionnement d'outil pour véhicules aériens sans équipage selon divers modes de réalisation de la présente divulgation.

### DESCRIPTION DÉTAILLÉE

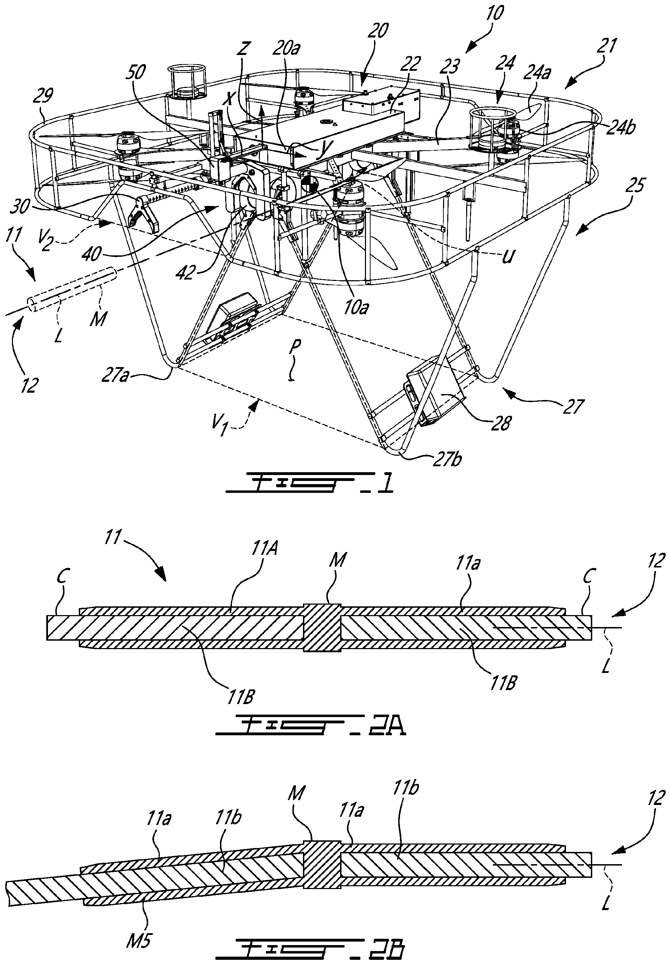

La figure 1 illustre un véhicule aérien sans équipage 10 (aussi appelé « *unmanned aerial vehicle* » ou « drone », ci-après l'« UAV 10 »). L'UAV 10 est prévu pour l'inspection d'un composant électrique 11 (ci-après le «composant 11 ») d'une ligne d'électricité 12. La ligne d'électricité 12 peut prendre plusieurs formes et comprend tous les différents types de ligne aérienne dans le domaine de la transmission d'un courant électrique. Elle est donc parfois désignée dans la présente description simplement comme « la ligne 12 ». À titre d'exemple et en référant à la figure 1, la ligne d'électricité 12 est une ligne de transmission d'électricité aérienne. Le composant 11 se trouve à même une portion de la ligne 12 suspendue à distance du sol. Tel que décrit plus en détail ci-dessous, l'UAV 10 peut être positionné à proximité du composant 11 tandis qu'un opérateur de l'UAV 10 peut se trouver à distance sécuritaire de la ligne 12, ne serait-ce qu'au sol en-dessous de la ligne 12. Divers modes de communication peuvent être utilisés pour fins de contrôle de l'UAV 10. Par exemple, la communication via réseau cellulaire ou satellite peut permettre le contrôle de l'UAV 10 par un opérateur hors-site. L'utilisation de l'UAV 10 pour fins de surveillance du composant 11 de la ligne 12 s'avère donc d'autant plus avantageuse lorsque celui-ci est situé à un endroit vers lequel l'envoi de personnel exigerait un moyen de transport spécialisé, comme par exemple un hélicoptère.

L'UAV 10 comprend un corps 20, un outil de surveillance 30 monté au corps 20, un ensemble de déplacement 40 pour déplacer l'UAV 10 par rapport à la ligne 12, ainsi qu'un système de positionnement 50 via lequel l'outil de surveillance 30 est monté au corps, permettant de déplacer l'outil de surveillance 30 par rapport au corps 20.

Le corps 20 est une composante structurelle de l'UAV 10 prévue pour supporter, contenir et/ou relier entre eux divers membres ou organes de l'UAV 10. Le corps 20 peut prendre toute forme appropriée pour réaliser une telle fonctionnalité. Le corps 20 comporte un système de propulsion 21 pour fournir une certaine portance et/ou poussée à l'UAV 10 pour fins de déplacement aérien (ou navigation aérienne) contrôlable via une unité de commande de l'UAV 10. Dans la figure 1, le corps 20 comporte un boîtier 22 qui contient l'unité de commande de l'UAV 10. L'unité de commande échange avec un ordinateur distant pour la transmission de données acquises par l'UAV 10 et la réception d'instructions émises par exemple de manière sélective par l'opérateur et/ou de manière automatisée via l'ordinateur. L'unité de commande comporte un processeur qui exécute des algorithmes pour aider au fonctionnement de l'UAV 10, par exemple en traitant les données reçues et celles destinées à être transmises. Dans d'autres modes de réalisation, l'unité de commande peut opérer selon des instructions de vol autonome stockées en mémoire située à même l'UAV 10. Depuis le corps 20, des bras 23 de l'UAV 10 s'étendent vers l'extérieur du boîtier 22 vers des ensembles de rotor 24 du système de propulsion 21. Chacun des ensembles de rotor 24 inclut une hélice 24a et un moteur électrique 24b pour entraîner l'hélice 24a. L'unité de commande communique avec et coordonne les ensembles de rotor 24 pour générer une élévation pour l'UAV 10 et pour le manœuvrer en vol en réponse aux instructions de télécommande fournies par l'opérateur. Plusieurs composantes sont envisagées pour assister à la navigation de l'UAV 10, par exemple une caméra visuelle, un système lidar (« *light detection and ranging* ») ou autre système approprié pour fournir une indication de la position de l'UAV 10 par rapport à son environnement, comme par exemple la ligne 12 et ses composants 11. Cette rétroaction est communiquée par l'unité de commande au technicien et l'aide à diriger l'UAV 10 par rapport à la ligne 12.

Un train d'atterrissage 25 est monté au corps 20 via les bras 23 et s'étend verticalement vers le bas relativement au corps 20. Le train d'atterrissage 25 comporte un piètement 27 définissant un plan d'appui P. Le piètement 27 permet de supporter le poids du corps 20 et des autres composantes de l'UAV 10 lorsque le piètement 27 est positionné sur un sol plan et horizontal de sorte que le plan d'appui P soit parallèle au sol. Le piètement 27 est configuré pour former deux parties respectivement de part et d'autre d'un axe longitudinal U de l'UAV 10, soient deux pieds 27a, 27b espacés l'un de l'autre. Notons ici qu'un système d'axes tri-dimentionnel propre à l'UAV 10 est défini par un axe X parallèle à l'axe U et dirigé vers un premier côté 20a du corps 20, un axe Z parallèle à une direction normale au plan d'appui P, et un axe Y orthogonal aux axes X et Z. Des batteries 28 de l'UAV 10 sont installées sur le train d'atterrissage 25 adjacents aux pieds 27a, 27b. Ce positionnement des batteries 28 permet une répartition de la masse de l'UAV 10 de sorte qu'un centre de gravité 10a de l'UAV 10 soit abaissé par rapport au corps 20. Le centre de gravité 10a de l'UAV 10 ainsi abaissé confère à l'UAV 10 une stabilité et un équilibre améliorés lorsqu'il n'est pas soutenu à l'horizontale, par exemple lorsqu'il repose sur la ligne 12.

À cette fin, l'ensemble de déplacement 40 de l'UAV 10 est situé sous le corps 20 entre les pieds 27a, 27b, et définit l'axe U. Dans la figure 1, l'ensemble de déplacement 40 comprend des éléments roulants 42 reliés au corps 20 de manière pivotable, situés l'un à la suite de l'autre et respectivement près du premier côté 20a du corps 20 et à proximité d'un deuxième côté du corps 20 opposé au premier côté 20a. L'UAV 10 est configuré de sorte qu'un dégagement, ou volume non-obstrué V1 (ci-après le « volume V1 ») s'étende entre les pieds 27a, 27b depuis le plan d'appui P jusqu'à l'ensemble de déplacement 40. Le volume V1 est donc ouvert selon l'axe Z au niveau du plan P, et selon l'axe X de part et d'autre des pieds 27a, 27b et de part et d'autre de l'ensemble de déplacement 40. Cette configuration de l'UAV 10 permet donc à celui-ci d'enjamber la ligne 12, c'est-à-dire d'être positionné par rapport à la ligne 12 de sorte que l'ensemble de déplacement 40 repose sur la ligne 12 alors que les pieds 27a, 27b s'étendent vers le bas de part et d'autre de la ligne 12. Bien que la portion de la ligne 12 soit suspendue et puisse définir une parabole entre deux structures de support situées de part et d'autre, la ligne 12 peut être discrétisée en segments linéaires s'étendant chacun le long d'un axe L. L'UAV 10 peut être positionné de sorte que l'axe U soit orienté selon l'axe L, par exemple en reposant sur la ligne 12 par l'entremise de l'ensemble de déplacement 40. Une cage 29 supportée par les bras 23 entoure le corps 20, formant ainsi une enceinte de protection pour maintenir une distance entre les composantes de l'UAV 10 se trouvant à l'intérieur de la cage 29 et l'environnement externe. La cage 29 contourne le volume V1, de sorte que la ligne 12 et le composant 11 puissent être reçus à l'intérieur du volume V1 à proximité du corps 20. On comprendra que le corps 20 n'est pas limité à la configuration décrite ci-dessus et que d'autres configurations pour le corps 20 entrent dans le cadre de la présente divulgation. Le composant 11 à surveiller peut correspondre à une quelconque structure de la ligne 12, par exemple une portion d'un quelconque câble conducteur de la ligne 12, qu'il soit sous tension ou non. Dans l'exemple illustré, le composant 11 auprès duquel l'UAV 10 est envoyé est un élément de jonction de la ligne 12. Dans l'une des multiples formes envisageables, l'élément de jonction est un manchon M.

À la figure 2A, il est permis de constater que le manchon M est doté de deux extrémités opposées ayant chacune un connecteur 11a prévu pour recevoir une extrémité 11b d'un câble conducteur C (ci-après, le « câble C ») de la ligne 12. Une première extrémité 11b d'un premier câble C de la ligne 12 s'étend selon l'axe L. Un premier connecteur 11a du manchon M a une forme allongée épousant celle de la première extrémité 11b.

En faisant référence à la figure 2B, bien que le composant 11 et le premier câble C puissent tous les deux s'étendre généralement selon l'axe L, le composant 11 peut présenter des surfaces dont la position et/ou l'orientation par rapport à l'axe L varie localement. L'un des connecteurs 11a peut être excentré par rapport à l'autre et/ou par rapport à l'axe L. Dans certains cas, une portion M5 du manchon M ayant l'un des connecteurs 11a peut dévier par rapport à l'autre connecteur 11a et/ou par rapport à l'axe L. Une telle déviation plastique peut être exprimée selon un angle auquel se trouve un point de la portion M5 déviée du manchon M par rapport à un point correspondant d'une portion du manchon M alignée avec l'axe L. Cette déviation peut par exemple survenir lors de l'installation du manchon M sur la ligne 12. En effet, une presse hydraulique pourrait être utilisée pour assembler les extrémités 11b des câbles C au manchon M. La pression appliquée par la presse peut causer la portion M5 du manchon M de dévier par rapport à l'autre portion du manchon M, tel qu'illustré à la figure 2B. Une telle déviation de la portion M5 du manchon M entraînera également la déviation de l'extrémité 11b du câble C recouverte par la portion M5.

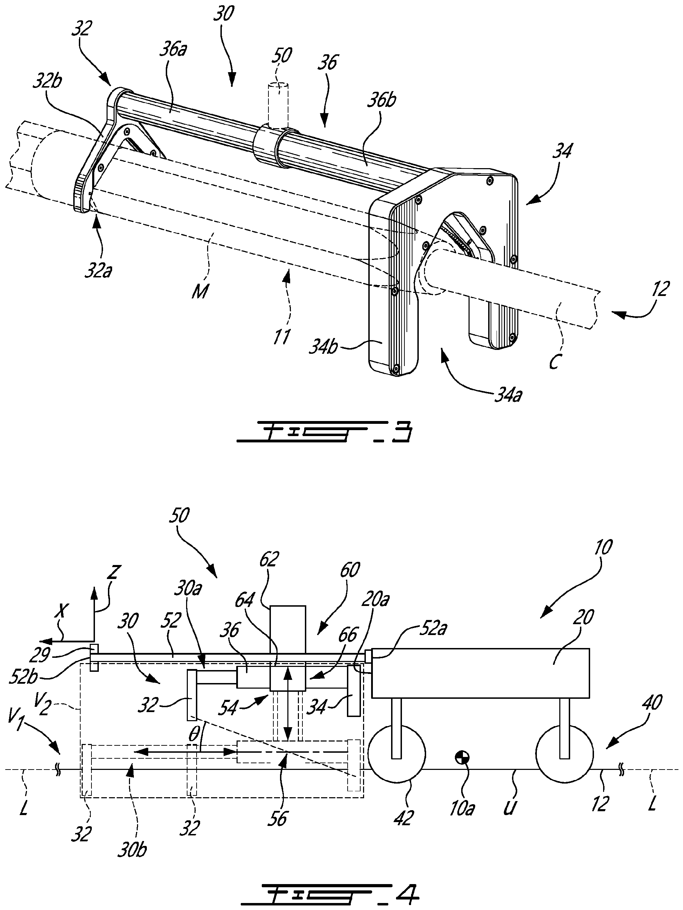

Référant à la figure 3, l'outil de surveillance 30 (parfois désigné ici simplement « outil 30 ») sera maintenant décrit plus en détails. L'outil 30 comporte deux dispositifs de mesure de résistance 32, 34, chacun d'eux étant utilisé pour mesurer la résistance électrique de l'un des composants de la ligne 12. Les dispositifs de mesure de résistance 32, 34 (parfois simplement désignés ici « dispositifs 32, 34 ») sont supportés respectivement par le manchon M et le câble C de la ligne 12. Comme cela sera expliqué plus en détail ci-dessous, les dispositifs 32, 34 sont adaptés pour être positionnés à distance l'un de l'autre et en contact électrique direct avec le composant 11 de sorte que la résistance électrique du composant 11 entre les dispositifs 32, 34 puisse être mesurée via l'outil 30.

Dans figure 3, les dispositifs 32, 34 sont reliés à un élément allongé 36 pour former l'outil 30. C'est d'ailleurs par l'entremise de l'élément allongé 36 que l'outil 30 est joint au système de positionnement 50, lequel s'étendant depuis le corps 20 et depuis l'extérieur du premier côté 20a du corps 20. Ainsi monté, les dispositifs 32, 34 sont situés de part et d'autre de la jonction entre l'élément allongé 36 et le système de positionnement 50, alors que l'outil 30 s'étend en s'éloignant du premier côté 20a du corps 20. Le dispositif 32 peut donc être désigné « dispositif distal 32 », tandis que le dispositif 34 peut être désigné « dispositif proximal 34 ». L'élément allongé 36 est télescopique et comporte un élément tubulaire intérieur 36a pouvant être déplacé à l'intérieur et par rapport à un élément tubulaire extérieur 36b. Les éléments tubulaires intérieur et extérieur 36a, 36b peuvent être déplacés l'un par rapport à l'autre pour faire varier la distance séparant les dispositifs 32, 34, afin d'augmenter ou de réduire cette distance. Dans une configuration de l'outil 30 parmi celles envisageables, l'élément tubulaire intérieur 36a est attaché au dispositif distal 32 et l'élément tubulaire extérieur 36b est attaché au dispositif proximal 34. L'outil 30 est joint au système de positionnement via l'élément tubulaire extérieur 36b. L'élément allongé 36 peut comporter des fils, des tiges ou d'autres liaisons pour assurer une connexion électrique entre les dispositifs 32, 34. L'élément allongé 36 peut également comporter un processeur pour mesurer la résistance électrique avec les dispositifs 32, 34 et pour communiquer sans fil la résistance électrique mesurée du composant 11.

Chacun des dispositifs 32, 34 a une forme arquée entourant partiellement un espace 32a, 34a correspondant. Dans cette réalisation, les deux dispositifs 32, 34 sont chacun munis d'une paire de branches 32b, 34b disposées de part et d'autre de l'espace 32a, 34a correspondant. Les dispositifs 32, 34 sont disposés de sorte que les espaces 32a, 34a sont vis-à-vis et ouverts selon une même direction, de sorte que le composant 11 puisse être reçu par les espaces 32a, 34a selon cette direction. Une fois le composant 11 reçu par lesdits espaces 32a, 34b, le contact électrique avec le composant 11 peut être établi par chacun des dispositifs 32, 34 via l'une ou l'autre des branches 32b, 34b. Une distance entre les branches 32b du dispositif distal 32 pourrait être au moins égale au diamètre du manchon M, tandis qu'une distance entre les branches 34b du dispositif proximal 34 pourrait être au moins égale au diamètre du câble C.

L'outil 30 est utilisé pour surveiller l'état du câble C, du manchon M et/ou de la jonction entre ceux-ci, c'est-à-dire l'état du composant 11. Bien que représenté et décrit ici comme étant utilisé principalement à des fins de diagnostic, l'outil 30 dans d'autres modes de réalisation est utilisé pour des interventions sur la ligne 12. Ces interventions incluent, mais sans s'y limiter, des tâches d'inspection, de réparation ou de maintenance. Dans le mode de réalisation illustré, l'outil 30 inclut un ohmmètre et est utilisé pour mesurer la résistance électrique du câble C, du manchon M et/ou du composant 11. La résistance électrique du composant 11 est déterminée en connaissant ou en mesurant l'ampérage du câble C, puis en mesurant la chute de tension due à la résistance du composant 11 (ou de tout autre composant) testé. On comprendra que la résistance électrique du composant 11, généralement exprimée en ohm (Ω), est une mesure de la difficulté à faire passer un courant électrique à travers ce composant 11. Si le composant 11 génère une résistance électrique supérieure, cela peut indiquer que le composant 11 est physiquement endommagé et nécessite donc une inspection quant à la nature de l'endommagement, une réparation ou un remplacement ultérieurs. La résistance électrique du composant 11 peut également être utilisée comme indicateur de l'état de dégradation physique du composant 11. Dans une autre forme de réalisation, l'outil 30 inclut un dispositif pour déterminer l'étendue de la protection galvanique sur le conducteur 11B et/ou le composant 11. Dans un autre mode de réalisation, l'outil 30 inclut un dispositif à rayons X pour capturer des images de l'intérieur du composant 11. Dans encore un autre mode de réalisation alternatif, l'outil 30 inclut un élément abrasif destiné à être frotté contre une surface extérieure du composant 11 pour en retirer une couche de débris, de glace ou de matériau dégradé. On comprendra ainsi que l'outil 30 n'est pas limité au mode de réalisation illustré et que d'autres types d'outils 30 de surveillance du composant 11 entrent dans le cadre de la présente divulgation.

Comme cela sera décrit plus en détail ci-dessous, l'outil 30 peut être déplacé par rapport au corps 20. Notamment, l'outil 30 est déplaçable verticalement par l'entremise du système de positionnement 50, par exemple selon l'axe Z, entre une première position surélevée et une seconde position abaissée. Ceci permet entre autres de déplacer l'UAV 10 le long de la ligne 12 vers le composant 11 jusqu'à ce que l'outil 30 soit à proximité du composant 11, et ce sans que le déplacement de l'UAV 10 ne soit entravé ni au niveau de l'ensemble de déplacement 40, ni au niveau de l'outil 30. L'outil 30 est aussi pivotable par l'entremise du système de positionnement 50, et ce depuis diverses positions entre la position surélevée et la position abaissée. Cet agencement permet avantageusement à l'outil 30 de suivre une forme du composant 11 au fur et à mesure que l'UAV 10 se déplace le long de la ligne 12 avec l'outil 30. Autrement dit, l'UAV 10 peut être déplacé le long de la ligne 12 pour déplacer l'outil 30 relativement au composant 11 de sorte qu'une orientation de l'outil 30 par rapport au corps 20 de l'UAV 10 soit modifiée conformément à une orientation du composant 11 par rapport à la ligne 12.

Le système de positionnement 50 est agencé au corps 20 de sorte que l'outil 30 est déporté. Le terme « déporté » signifie que l'outil 30, en tout ou en partie, est décalé selon l'axe X par rapport au premier côté 20a du corps 20, à l'ensemble de déplacement 40 et/ou au centre de gravité 10a de l'UAV. Le terme « déporté » signifie que l'outil 30 est décalé pour s'allonger en parallèle à l'axe L du câble C par rapport au premier côté 20a du corps 20, à l'ensemble de déplacement 40 et/ou au centre de gravité 10a de l'UAV. Cette configuration déportée de l'outil 30 fait en sorte que l'outil 30 devance le corps 20 et l'ensemble de déplacement 40 alors que l'UAV 10 se déplace le long de la ligne 12 vers le composant 11, le corps 20 étant orienté de sorte que l'axe U soit généralement parallèle à l'axe L.

Dans la figure 4, l'outil 30 entier est déporté par rapport au premier côté 20a du corps 20, le dispositif proximal 34 étant plus près du corps 20 que le dispositif distal 32. L'outil 30 se trouve surélevé par rapport à l'ensemble de déplacement 40 dans la première position (montrée à 30a). Dans la deuxième position (montrée à 30b en lignes pointillées), l'outil 30 est au niveau de l'ensemble de déplacement 40. Cette configuration du système de positionnement 50 permet d'ajuster la position verticale de l'outil 30 selon une position verticale du composant 11 par rapport à l'axe L. Dans certaines réalisations, l'ensemble de déplacement 40 est monté au corps 20 de façon à permettre un déplacement relatif selon l'axe Z, et donc d'éloigner le corps 20 et le système de positionnement 50 de la ligne 12 alors que l'ensemble de positionnement 40 est appuyé sur la ligne 12. Le système de positionnement 50 permet donc d'ajuster la position verticale de l'outil 30 pour compenser l'éloignement du corps 20 par rapport à l'ensemble de déplacement 40, c'est-à-dire l'éloignement du corps 20 par rapport à l'axe U.

En faisant référence à la figure 4, le système de positionnement 50 comprend un module de déplacement 60 doté d'un premier membre 62 monté au corps 20 et d'un deuxième membre 64 couplé au premier membre 62 par l'entremise d'un joint cinématique 54 dit déporté, permettant le déplacement vertical du deuxième membre 64 par rapport au premier membre 62. Le système de positionnement 50 comprend aussi un porte-outil 66 couplé au deuxième membre 64 par l'entremise d'un joint 56 dit distal, permettant le pivotement du porte-outil 66 par rapport au deuxième membre 64 selon un ou plusieurs degrés de liberté, dont l'un des degrés de liberté est représenté schématiquement dans la figure 4 avec un angle ⊖. Le porte-outil 66 (et l'outil 30 qu'il supporte) est donc déplaçable verticalement avec le deuxième membre 64 par rapport au premier membre 62, et pivotable par rapport au deuxième membre 64, tout en étant déporté par rapport au centre de gravité 10a du corps 20 et par rapport à l'ensemble de déplacement 40.

Plusieurs configurations du système de positionnement 50 sont possibles pour réaliser cette fonctionnalité. À titre d'exemple, et en référant à la figure 4, le système de positionnement 50 inclut un bras de support 52 s'étend longitudinalement du premier côté 20a du corps 20 depuis une première extrémité 52a fixée au corps 20 sur son premier côté 20a jusqu'à une deuxième extrémité 52b sur le premier côté 20a et éloignée du corps 20. La deuxième extrémité 52b est fixée à la cage 29. Dans certaines configurations envisageables, la deuxième extrémité 52b est libre. Le premier membre 62 du module de déplacement 60 est fixé au bras de support 52 à distance du corps 20 sur son premier côté 20a, de sorte que le deuxième membre 64 est déplaçable verticalement avec le porte-outil 66 relativement au bras de support 52 et ce à distance du corps 20 sur son première côté 20a. Le bras de support 52 surplombe un volume de travail non-obstrué V2 de l'UAV 10 (ci-après, le « volume de travail V2 »). Le bras de support 52 définit une limite verticale supérieure du volume de travail V2, qui s'étend verticalement jusqu'à une limite verticale inférieure située plus près de l'axe U de l'UAV 10 que du bras de support 52. Le volume de travail non-obstrué V2 est positionné uniquement sur le côté 20a du corps, où se trouve l'outil 30. Dans certaines réalisations, la limite verticale inférieure du volume de travail V2 est située entre l'axe U et le plan d'appui P. Alternativement, le premier membre 62 du module de déplacement 60 pourrait être monté autrement, par exemple à une membrure soutenant le système de propulsion 21 ou même à une membrure de la cage 29. Le bras de support 52 pourrait alors être omis. Le premier membre 62 pourrait par ailleurs être monté directement au corps 20, en quel cas le deuxième membre 64 pourrait avoir une forme allongée dotée d'une extrémité jointe au premier membre 62 et d'une deuxième extrémité déportée à laquelle le porte-outil 66 serait joint.

En faisant référence à la figure 4, le module de déplacement 60 est configuré de sorte que le deuxième membre 64 est déplaçable par rapport au premier membre 62, situé à la limite verticale supérieure, pour déplacer le porte-outil 66 jusqu'à la limite verticale inférieure du volume de travail V2. Ainsi, une fois l'outil 30 monté au porte-outil 66 et l'UAV 10 placé sur la ligne 12, l'outil 30 est déplaçable par l'entremise du module de déplacement 60 pour être rapproché de l'axe U jusqu'à ce que l'un ou l'autre des dispositifs 32, 34 de l'outil 30 entre en contact avec la ligne 12. Advenant qu'un seul des deux dispositifs 32, 34 entre en contact avec la ligne 12, le joint cinématique déporté 54 et le joint distal 56 coopèrent de sorte que le dispositif 32, 34 étant entré en contact avec la ligne 12 agisse en levier pour pivoter l'outil 30 et le porte-outil 66 par rapport au deuxième membre 64 au fur et à mesure que le deuxième membre 64 est rapproché de l'axe U, jusqu'à ce que l'autre dispositif 32, 34 entre lui aussi en contact avec la ligne 12.

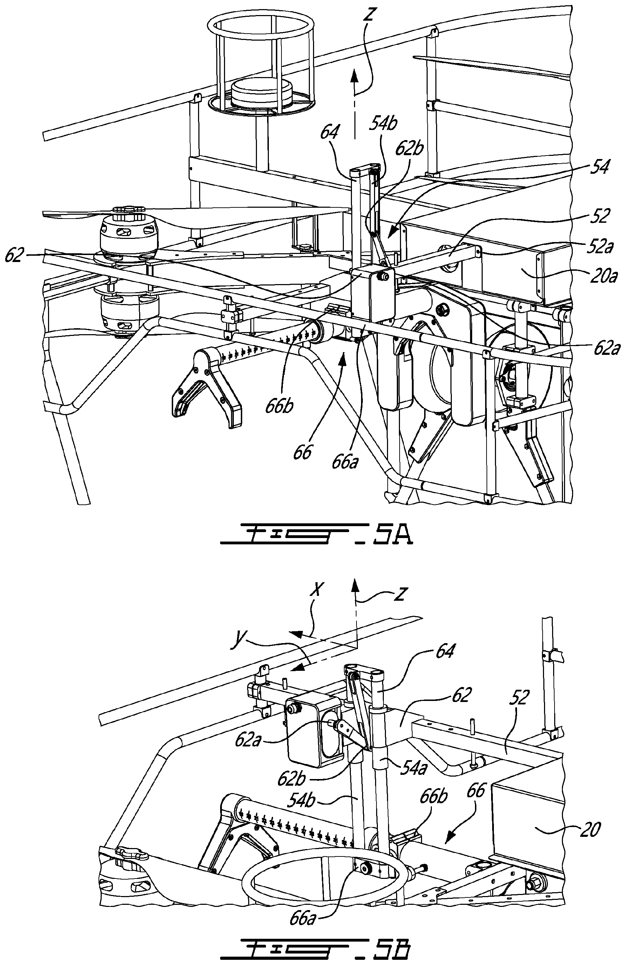

Le module de déplacement 60 et les joints 54, 56 seront maintenant décrits plus en détail alors que référence sera faite aux figures 5A et 5B. Le joint cinématique déporté 54 est un joint prismatique doté d'un seul degré de liberté, soit la translation verticale selon un axe parallèle à l'axe Z. Dans cette réalisation, le joint cinématique déporté 54 comprend une glissière, ou coulisse 54a, fixée au bras de support 52 et faisant partie du premier membre 62 du module de déplacement 60, ainsi qu'un membre mobile, ou coulisseau 54b, dont le déplacement est contraint par la coulisse 54a et faisant partie du deuxième membre 64. Dans cette réalisation, la coulisse 54a et le coulisseau 54b sont présents en deux instances appariées, formant une paire de joints cylindriques agencés pour bloquer toute rotation du coulisseau 54b par rapport à l'axe Z. Le joint cinématique déporté 54 peut toutefois comprendre une seule coulisse 54a et un seul coulisseau 54b présentant des géométries anti-rotationnelles complémentaires.

En faisant référence aux figures 5A et 5B, le joint cinématique déporté 54 est actionné par un moteur 62a du premier membre 62, situé dans un boîtier fixé au bras de support 52. Le moteur 62a, relié électriquement aux batteries 28 et électroniquement à l'unité de contrôle de l'UAV 10, est muni d'un arbre pouvant être entraîné en rotation horaire ou anti-horaire selon un axe ayant une composante parallèle à l'axe X. Une bielle 62b reliant l'arbre du moteur 62a au coulisseau 54b permet de transformer le mouvement rotatif du moteur 62a en mouvement vertical du deuxième membre 64 par rapport au premier membre 62. À la figure 5A, la bielle 62b est en extension alors que le deuxième membre 64 et le porte-outil 66 sont en position surélevée. À la figure 5B, la bielle 62b est en flexion alors que le deuxième membre 64 et le porte-outil 66 sont en position abaissée. La figure 5B permet aussi de voir que la coulisse 54a est décalée par rapport au bras de support 52 selon l'axe Y, tandis que le porte-outil 66 est décalé par rapport au coulisseau 54b en direction inverse de sorte que l'outil 30 est situé sous le bras de support 52 une fois monté au porte-outil 66. Cet alignement du porte-outil 66 par rapport au bras de support 52 fait en sorte qu'une force transmise au porte-outil 66 selon l'axe X, par exemple dûe à de la friction ou des impacts rencontrés par l'outil 30 alors que l'outil 30 est déplacé par l'UAV 10 le long de la ligne 12, n'engendrerait pas de moment de rotation significatif au bras de support 52, et donc au corps 20, autour de l'axe Z. Le moteur 62a qui actionne le joint déportée 54 permet d'ajuster la hauteur de l'outil 30 par rapport au conducteur C ou au manchon M, et permet également à l'outil 30 d'exercer une pression ou force de contact contre le composant à surveiller.

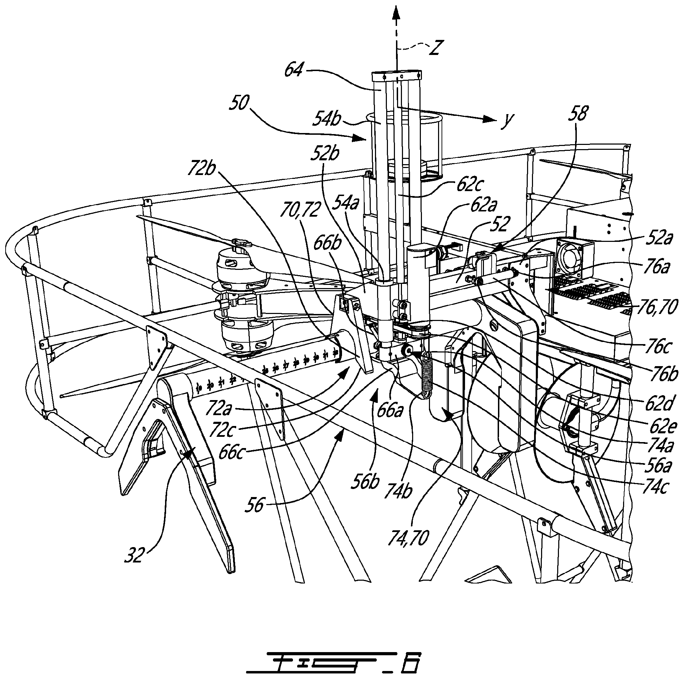

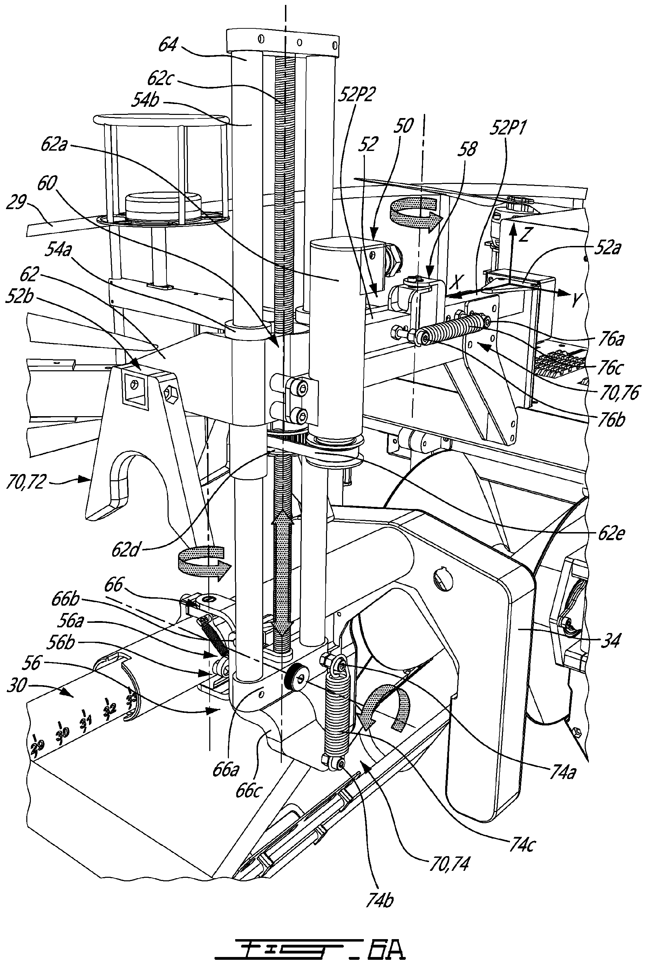

Faisant référence à la figure 6, le joint distal 56 est un joint de révolution comprenant une partie fixe 66a fixée à l'extrémité du coulisseau 54a et une partie pivotable 66b et décalée, via laquelle l'outil 30 peut être monté. Le joint distal 56 est configuré de sorte qu'un mouvement de tangage du porte-outil 66 avec l'outil 30 est possible, c'est-à-dire un mouvement de pivot autour d'un axe ayant une composante parallèle à l'axe Y. Le porte-outil 66 est donc pivotable à un angle de tangage par rapport à une orientation standard, laquelle est dans ce cas-ci définie par le corps 20 et parallèle aux axes X et U.

Faisant référence aux figures 6 et 6A, un autre mode de réalisation de la présente technologie est montré et sera décrit ci-après. Le joint distal 56 permet un pivotement du porte-outil 66 par rapport au deuxième membre 64 selon un axe ayant une composante parallèle à l'axe Z. Le joint distal 56 est donc configuré de sorte qu'un premier mouvement de lacet du porte-outil 66 avec l'outil 30 est rendu possible. Le porte-outil 66 est donc pivotable à un premier angle de lacet par rapport à l'orientation standard. Dans cette réalisation, le joint distal 56 permet au porte-outil 66, et donc à l'outil 30 aussi, de pivoter selon un mouvement de lacet et un mouvement de tangage par rapport au deuxième membre 64. Le joint distal 56 comprend le joint de révolution ayant la partie fixe 66a fixée à l'extrémité du coulisseau 54b, désigné dans un tel cas comme un premier joint 56b du joint distal 56 permettant le mouvement de lacet. Le joint distal 56 comprend une partie intermédiaire 66c, laquelle est pivotable avec la partie pivotable 66b par rapport à la partie fixe 66a pour générer le mouvement de tangage, ces parties 66b,66c pouvant être désignées comme un deuxième joint 56a du joint distal 56. La partie intermédiaire 66c s'étend depuis l'extrémité du coulisseau 54b jusqu'à la partie pivotable 66b, dans ce cas-ci depuis en dessous de l'extrémité du coulisseau 54b jusqu'en dessous de la partie pivotable 66b. La partie pivotable 66b, sur laquelle l'outil 30 est monté, est pivotable par rapport à la partie intermédiaire 66c selon de l'axe ayant la composante parallèle à l'axe Z pour générer le premier mouvement de lacet au niveau du porte-outil 66. Cette configuration structurelle du joint distal 56 est montrée à titre d'exemple, alors que plusieurs variantes sont envisageables et peuvent conférer les degrés de liberté adéquats pour permettre les mouvements de tangage et/ou de lacet au niveau du porte-outil 66. Entre autres alternatives, le premier et le deuxième joint 56b, 56a du joint distal 56 peuvent être remplacés par un joint sphérique.

Faisant référence aux figures 6 et 6A, le système de positionnement 50 est muni d'un moyen d'orientation 70. Un guide 72 du moyen d'orientation 70 est attaché au bras de support 52 et coopère avec l'outil 30 pour contraindre celui-ci à pivoter vers l'orientation standard alors que le module de déplacement 60 remonte l'outil 30 vers la position surélevée. Le guide 72 est une structure de forme arquée entourant partiellement une cavité 72a ouverte vers le bas, dotée de deux branches 72b disposées de part et d'autre de la cavité 72a. Chaque branche 72b est munie d'une surface 72c s'étendant depuis une extrémité de la branche 72b vers la cavité 72a. La surface 72c est orientée de sorte que l'outil entrant en contact avec la surface 72c alors qu'il est orienté au premier angle de lacet sera dirigé vers l'orientation standard au fur et à mesure qu'il glisse vers la cavité 72a le long de la surface 72c, tel que montré à la figure 6. Le moyen d'orientation 70 comprend aussi un moyen de biais 74, comprenant un premier point d'attache 74a lié au deuxième membre 64 du module de déplacement 60, un deuxième point d'attache 74b lié à la partie intermédiaire 66c du joint distal 56 et un élément résilient 74c ayant deux parties distancées l'une de l'autre et respectivement attachées à l'un des points d'attaches 74a, 74b. L'élément résilient 74c est dans ce cas-ci un ressort métallique de forme hélicoidale, mais d'autres types d'éléments résilients sont possibles. L'élément résilient 74c est configuré de sorte qu'une déformation réversible est induite dans l'élément résilient 74c au fur et à mesure que l'angle de tangage augmente par rapport à l'orientation standard, et dans ce cas-ci plus particulièrement lorsque mouvement de tangage élève le dispositif distal 32 verticalement, engendrant une tension dans l'élément résilient 74c. Un tel mouvement peut se produire en présence d'une dénivellation verticale dans la ligne 12, par exemple lorsque le dispositif distal 32 est en contact avec le premier câble conducteur C de la ligne 12 et se voit déplacé sur le manchon M de la ligne 12, agissant comme une rampe forçant un mouvement de tangage d'une ampleur suffisante pour que le dispositif distal 32 franchisse la dénivellation entre le câble C et le manchon M. Advenant un retrait du dispositif distal 32 depuis le manchon M vers le câble C, l'élément résilient 74c se verrait sa forme initiale restituée, induisant ainsi un mouvement de tangage ramenant le porte-outil 66 et l'outil 30 vers l'orientation standard.

Faisant référence aux figures 6 et 6A, le système de positionnement 50 comprend un joint cinématique proximal 58. Le bras de support 52 est configuré en deux parties. Une première partie 52P1 ayant la première extrémité 52a est montée au corps 20, tandis qu'une deuxième partie 52P2 du bras de support 52 ayant la deuxième extrémité 52b est pivotable par rapport à la première partie 52P1, et ce par l'entremise du joint cinématique proximal 58 entre les deux parties 52P1,52P2 du bras de support 52. Le joint cinématique proximal 58 correspond dans ce cas-ci à un joint de révolution. La deuxième extrémité 52b est libre et peut librement déplacer dans la configuration des figure 6 et 6A car elle n'est pas reliée à une structure externe telle que la cage 29. La deuxième partie 52P2 du bras de support 52 est donc pivotable au-dessus du volume de travail V2 selon un axe ayant une composante parallèle à l'axe Z. Comme le module de déplacement 60 est monté à la deuxième partie 52P2 du bras de support 52, le joint cinématique proximal 58 est configuré de sorte qu'un deuxième mouvement de lacet du porte-outil 66 avec l'outil 30 est rendu possible par le pivotement de la deuxième partie 52P2 du bras de support 52. Le porte-outil 66 est donc pivotable à un deuxième angle de lacet par rapport à l'orientation standard. Le moyen d'orientation 70 comprend un moyen de biais 76 dit proximal. Ce moyen de biais proximal 76 comprends un premier point d'attache 76a lié à la première partie 52P1 du bras de support 52, un deuxième point d'attache 76b lié à la deuxième partie 52P2 du bras de support 52 et un élément résilient 76c ayant deux parties distancées l'une de l'autre et respectivement attachées à l'un des points d'attaches 76a, 76b. L'élément résilient 76c est dans ce cas-ci un ressort métallique de forme hélicoidale, mais d'autres types d'éléments résilients sont possibles. Le moyen de biais proximal 76 est configuré de sorte qu'une déformation réversible est induite dans l'élément résilient 76c au fur et à mesure que le deuxième angle de lacet augmente par rapport à l'orientation standard, engendrant une tension dans l'élément résilient 76c. Un tel mouvement peut se produire en présence d'une dénivellation horizontale dans la ligne 12, par exemple lorsque le dispositif distal 32 en contact avec le premier câble conducteur C de la ligne 12 se voit déplacé sur le manchon M de la ligne 12, agissant comme une rampe forcant un mouvement de lacet d'une ampleur suffisante pour que le dispositif distal 32 franchisse la dénivellation entre le câble C et le manchon M. Advenant un retrait du dispositif distal 32 depuis le manchon M vers le câble C, l'élément résilient 76c se verrait sa forme initiale restituée, induisant ainsi un mouvement de lacet ramenant le porte-outil 66 et l'outil 30 vers l'orientation standard. Dans d'autres modes de réalisation du système de positionnement 50, l'une ou l'autre des composantes du moyen d'orientation 70 peut être agencée différemment ou même être omise.

Dans la réalisation montrée aux figures 6 et 6A, le moteur 62a est muni d'un arbre pouvant être entraîné en rotation horaire ou anti-horaire selon un axe ayant une composante parallèle à l'axe Z. Une vis 62c agencée au coulisseau 54b est reçue par une noix 62d agencée à la coulisse 54a, la noix 62d étant bloquée en translation mais libre de tourner autour d'un axe parallèle à celui du moteur 62a. Une courroie 62e reliant l'arbre du moteur 62a à la noix 62d permet de transformer le mouvement rotatif du moteur 62a en mouvement vertical du deuxième membre 64 par rapport au premier membre 62.

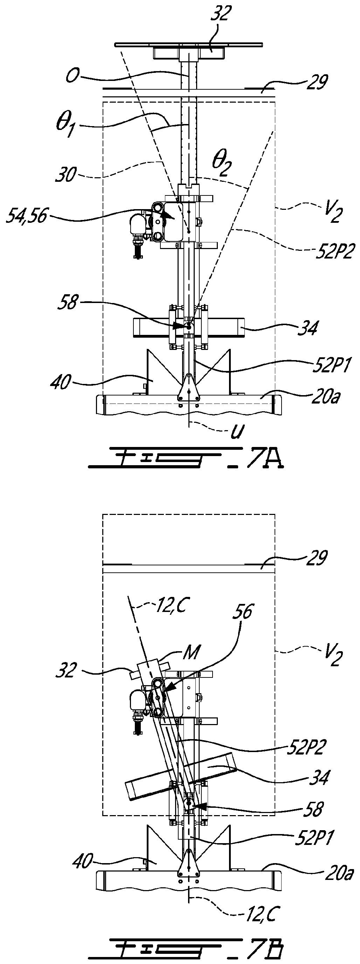

Aux figures 7A et 7B, certaines des positions de l'outil 30 rendues possibles par les joints 54, 56, 58 sont illustrées. À la figure 7A, l'orientation standard, montrée à O, et les portées de mouvement de lacet par rapport à l'orientation standard O sont montrées respectivement à Φ1 (incluant le premier angle de lacet de la partie intermédiaire 66c du porte-outil 66 par rapport au deuxième membre 64 du module de déplacement 60) et Φ2 (incluant le deuxième angle de lacet de la deuxième partie 52P2 du bras de support 52 par rapport à la première partie 52P1 du bras de support 52). La figure 7B illustre une position de l'outil 30 suite à des mouvements de lacet aux joints proximal 58 et distal 56 engendrés alors que l'orientation de l'outil 30 se conforme à une déviation de la manchon M et de la ligne 12 et que l'UAV 10 est supporté par la ligne 12 par l'entremise de l'ensemble de déplacement 40. L'alignement de l'outil 30 et sa capacité de conformer avec l'alignement de la ligne 12 ou du composant à surveiller se fait de manière passive. Les joints 54, 56, 58 permet un ajustement rotatif de l'outil 30 passif qui est déclenché lorsque l'outil 30 est déplacé par le système de positionnement 50 pour contacter le composant. Cet ajustement rotatif passif de l'outil 30 n'exige aucunement une application de force ou autre intervention de la part du système de positionnement 50.

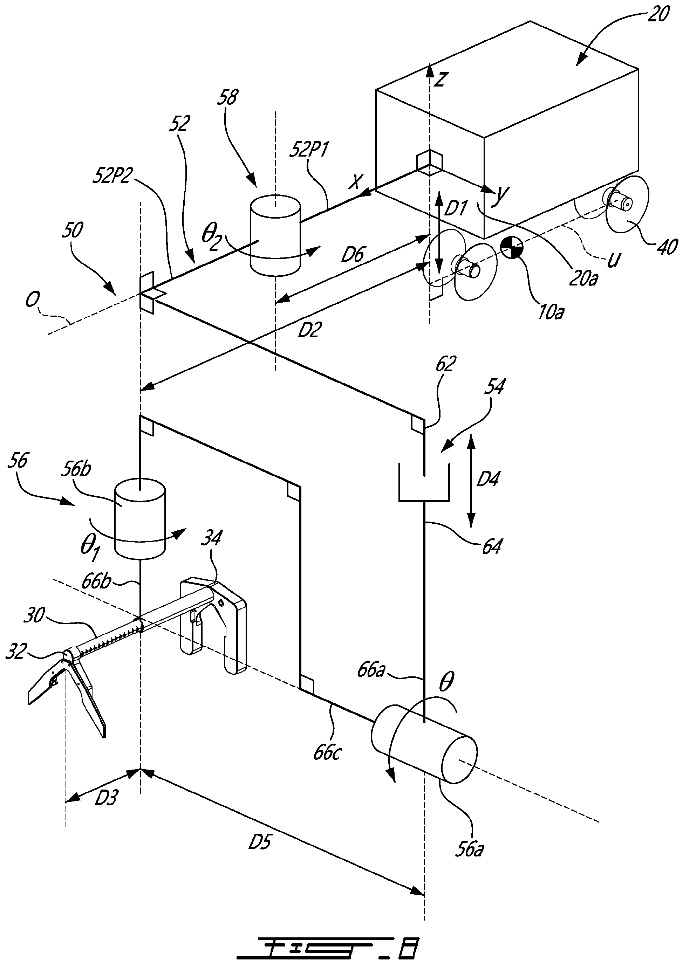

À la figure 8 se trouve une représentation schématisée d'une chaîne cinématique de l'UAV 10 et de divers paramètres de celle-ci dont les modalités peuvent différer dépendamment du mode de réalisation. L'axe X est parallèle à l'axe U et sont perpendiculaires à un même plan vertical. Une distance verticale D1 entre les axes X et U peut varier d'une réalisation à l'autre, et peut être variable dans certaines réalisations. Une variation de la distance D1 peut correspondre à un déplacement relatif entre le bras de support 52 et l'ensemble de déplacement 40, et par le fait même à un déplacement vertical du centre de gravité 10a de l'UAV 10. La distance D1 peut être établie de sorte que la position verticale du centre de gravité 10a favorise l'équilibre de l'UAV 10 par rapport à l'axe U, par exemple lorsque l'UAV 10 est supporté sur la ligne 12 par l'entremise de l'ensemble de déplacement 40.

Le joint cinématique déporté 54 est situé à une distance horizontale D2 du premier côté 20a du corps 20 selon l'axe X. La distance D2 peut par exemple être la distance, selon l'axe X et le bras de support 52, du premier côté 20a jusqu'au système de positionnement 50 via lequel l'outil 30 est monté au corps 20. La distance D2 peut par exemple être établie en fonction de la longueur de l'outil 30, soit la dimension entre les dispositifs 32, 34. Le dispositif distal 32 est situé à une distance horizontale D3 par rapport au joint déporté 54. Considérant que la configuration de l'outil 30 montrée à la figure 8 permet un ajustement de sa longueur, la distance D3 peut être variée manuellement, ou alors automatiquement par l'entremise d'un module de déplacement convenablement agencé aux éléments tubulaires intérieur et extérieur 36a, 36b de l'outil 30. La distance D3 peut être établie de sorte que le dispositif distal 32 puisse être positionné hors du volume de travail V2, par exemple au-delà du périmètre défini par la cage 39. Pour d'autres configurations de l'outil 30 qui ne permettent pas un ajustement de leurs longueurs, la distance D3 a une valeur de zéro.

Le joint déporté 54 est configuré pour engendrer un déplacement vertical du porte-outil 66 sur une distance D4. La distance D4 peut être établie, par exemple, de sorte que l'outil 30 puisse se rendre au moins jusqu'à l'axe U en position abaissée. La distance D4 peut être établie, par exemple, de sorte que l'outil 30 puisse se rendre au moins jusqu'à l'axe L de la ligne 12 en position abaissée.

Le joint distal 56, lorsque présent, est déplaçable verticalement à partir d'une position déportée selon l'axe X, et ce par l'entremise du joint déporté 54. Le joint distal 56 permet un pivotement de l'outil 30 par rapport au deuxième membre 64 selon un axe ayant une composante parallèle à l'axe Z. Le joint distal 56 comprend le premier joint 56b permettant le mouvement de lacet. L'outil 30 est donc pivotable au premier angle de lacet Φ1 par rapport à l'orientation standard O. Dans la réalisation de la figure 8, le joint distal 56 permet également un mouvement de tangage. Le joint distal 56 comprend le deuxième joint 56a qui est pivotable avec la partie pivotable 66b par rapport à la partie fixe 66a pour générer le mouvement de tangage selon l'angle θ. L'outil 30 est donc pivotable à un angle de tangage θ par rapport à l'orientation standard O. Le joint distal 56 est situé à une position verticale déterminée lorsque le joint déporté 54 est en position relevée. Dans les réalisations dont le joint distal 56 est doté des premier et deuxième joints 56a, 56b, tel que montré à la figure 8, une distance horizontale D5 non-zéro est définie entre ceux-ci indiquant que l'axe du premier angle de lacet est décalé dans une direction parallèle à l'axe Y de la première partie 52P1 du bras de support 52. Dans une autre réalisation possible où la distance D5 est zéro, les axes de rotation des premier et deuxième joints 56a, 56b se croisent en un point, permettant une orientation à l'outil 30 pour mieux s'accoupler au conducteur C ou manchon M.

Le joint proximal 58, lorsque présent, est situé entre le joint déporté 54 et le premier côté 20a du corps 20, à une distance D6 selon l'axe X du premier côté 20a. La première extrémité 52a de la première partie 52P1 bras de support 52 est montée au premier côté 20a du corps 20, tandis que la deuxième extrémité 52b est pivotable par rapport à la première partie 52P1, et ce par l'entremise du joint cinématique proximal 58. Le joint proximal 58 permet à la deuxième partie 52P2 du bras de support 52, et donc à l'outil 30 supporté indirectement par ce dernier, de pivoter selon le deuxième angle de lacet Φ2 par rapport à la première partie 52P1 du bras de support 52 et au corps 20. Les axes de rotation autour desquels les premier et deuxième angles de lacet Φ1, Φ2 sont définis sont parallèles et se sont distancés l'un de l'autre, permettant ainsi de déporter parallèlement l'outil 30 pour améliorer son alignement sur le conducteur C ou sur le manchon M. Faisant référence à la figure 8, l'axe du mouvement de translation verticale définit par le joint déporté 54 est parallèle à l'axe de rotation définit par le joint proximal 58. Selon la rotation effectuée dans l'angle de tangage θ au deuxième joint rotoïde 56a, l'axe de rotation du premier joint 56b peut aussi être parallèle à l'axe de rotation du joint proximal 58, permettant ainsi une déportation parallèle de l'outil 30 sur le côté 20a du corps 20. Dans une réalisation possible où la distance D5 est zéro, l'axe du mouvement de translation verticale définit par le joint déporté 54 et les axes de rotation des premier et deuxième joints 56a, 56b se croisent en un point. L'axe du mouvement de translation verticale définit par le joint déporté 54 est positionné ailleurs à une distance des premier et deuxième joints 56a, 56b dans un autre mode de réalisation possible.

Le système de positionnement 50 dont les degrés de liberté possibles sont représentés à la figure 8 permet un ajustement de l'outil 30 passif pour qu'il s'aligne mieux avec le composant 11 à surveiller. Dans la réalisation du système de positionnement 50 qui comprend les joints 54, 56, 58, le système de positionnement 50 définit ou comprend les quatre degrés de liberté suivants : trois degrés de libertés rotatifs permettant à l'outil 30 de se déplacer et s'orienter par rapport au corps 20 selon les premier et deuxième angles de lacet Φ1, Φ2 et selon l'angle de tangage θ, et un autre degré de liberté de translation permettant à l'outil 30 de se déplacer verticalement par rapport au corps 20. Dans la réalisation du système de positionnement 50 qui comprend les joints 54, 56, 58, l'ordre des degrés de liberté à partir du corps 20 du véhicule 10 est le suivant : 1) un degré de liberté rotatif au deuxième angle de lacet Φ2, 2) un degré de liberté de translation définit par le joint déporté 54, 3) un degré de liberté rotatif au premier angle de lacet Φ1, et 4) un degré de liberté rotatif à l'angle de tangage θ. Les quatre degrés de liberté qui forment la chaîne cinématique du système de positionnement 50 entre le corps 20 du véhicule 10 et l'outil 30 sont composés de trois joints rotoïdes (e.g. les joints 56a, 56b, 58) et un joint prismatique (e.g. le joint déporté 54).

En vue de ce qui précède, le lecteur appréciera que les distances D1-D6 ainsi que les plages de rotation et/ou de translation des divers joints 54, 56, 58 figurent au nombre des paramètres pouvant différer d'une réalisation à l'autre.

La description ci-dessus n'est donnée qu'à titre d'exemple et l'homme du métier reconnaîtra que des modifications peuvent être apportées aux modes de réalisation décrits sans sortir du cadre de la divulgation décrite. De telles modifications entrant dans le cadre de la présente divulgation seront apparentes à l'homme du métier à la lumière d'un examen de la présente divulgation, et sont destinées à être comprises dans la portée des revendications annexées.

## Revendications

1. Un véhicule aérien sans équipage (10) pouvant être monté relativement à une ligne électrique (12) pour surveiller un composant (11) de la ligne, le véhicule comprenant:
un corps (20) ayant des côtés et un système de propulsion (21) pour soulever, abaisser et diriger le véhicule relativement à la ligne;
un système de positionnement (50) d'outil incluant un module de déplacement (60) ayant un premier membre (62) monté au corps, un deuxième membre (64) déplaçable verticalement par rapport au premier membre, et un porte-outil (66) couplé pivotablement au deuxième membre; et
un outil de surveillance (30) montable au porte-outil (66) pour être positionné à distance du corps (20) sur un côté des côtés du corps et pour être déplaçable avec le porte-outil (66) relativement au corps pour être monté au composant ou autour du composant (11).

2. Le véhicule (10) selon la revendication 1, dans lequel le porte-outil (66) est pivotable à un angle de tangage et/ou à un angle de lacet, relativement au deuxième membre (64).

3. Le véhicule (10) selon la revendication 2, dans lequel le porte-outil (66) est pivotable à l'angle de tangage, et le système de positionnement (50) d'outil inclut un moyen d'orientation pour biaiser le porte-outil (66) depuis l'angle de tangage vers une orientation standard du porte-outil relativement au deuxième membre (64).

4. Le véhicule (10) selon l'une quelconque des revendications 1 à 3, dans lequel le système de positionnement (50) d'outil inclut un bras de support (52) s'étendant longitudinalement entre une première extrémité (52a) montée au corps (20) et une deuxième extrémité (52b) positionnée à distance du côté du corps, le premier membre (62) du module de déplacement (60) monté au bras de support à distance de la première extrémité sur le côté du corps.

5. Le véhicule (10) selon la revendication 4, dans lequel le bras de support (52) est pivotable relativement au corps (20) afin de pivoter le module de déplacement (60) et le porte-outil (66) relativement au corps à un angle de lacet.

6. Le véhicule (10) selon la revendication 5, dans lequel le système de positionnement (50) d'outil inclut un moyen pour biaiser le bras de support (52) depuis l'angle de lacet vers une orientation standard du bras de support.

7. Le véhicule (10) selon la revendication 5 en ce qu'elle dépend de la revendication 3, dans lequel le porte-outil (66) est pivotable à un premier angle de lacet par rapport au deuxième membre (64) selon un premier axe, le bras de support (52) étant pivotable à un deuxième angle de lacet par rapport au corps (20) selon un deuxième axe parallèle au premier axe.

8. Le véhicule (10) selon la revendication 5 en ce qu'elle dépend de la revendication 3, dans lequel l'outil de surveillance (30) est dans une orientation standard de l'outil de surveillance lorsque le bras de support (52) est dans l'orientation standard du bras de support et le porte-outil (66) est dans l'orientation standard du porte-outil (66).

9. Le véhicule (10) selon la revendication 8, dans lequel l'outil de surveillance (30) s'étend en-dessous du bras de support (52).

10. Le véhicule (10) selon la revendication 4, lequel définit un volume de travail non-obstrué en dessous du bras de support (52) et sur ledit côté des côtés du corps (20), le volume de travail non-obstrué dimensionné de sorte qu'une portion de la ligne (12) ayant le composant (11) puisse être reçue par le volume de travail non-obstrué, l'outil de surveillance (30) étant déplaçable via le système de positionnement (50) d'outil pour être monté à ou autour du composant dans le volume de travail non-obstrué.

11. Le véhicule (10) selon la revendication 10, lequel inclut une cage montée au corps (20) et circonscrivant au moins en partie le volume de travail non-obstrué, l'outil de surveillance (30) montable au porte-outil (66) pour s'étendre depuis le porte-outil à l'intérieur de la cage jusqu'à l'extérieur de la cage.

12. Le véhicule (10) selon l'une quelconque des revendications 1 à 11, dans lequel l'outil de surveillance (30) a un dispositif proximal et un dispositif distal positionné à distance du dispositif proximal, l'outil de surveillance (30) étant montable au porte-outil à un endroit entre le dispositif proximal et le dispositif terminal de sorte que le dispositif proximal est plus près du corps que le dispositif distal.

13. Le véhicule (10) selon la revendication 12, dans lequel l'outil de surveillance (30) est ajustable en longueur de façon à faire varier une distance entre le dispositif distal et le porte-outil (66).

14. Le véhicule (10) selon l'une quelconque des revendications 1 à 13, dans lequel le module de déplacement (60) inclut un moteur (62a) attaché au premier membre (62) et relié au deuxième membre (64) pour actionner le deuxième membre et dans lequel, optionnellement, le moteur (62a) est relié au deuxième membre par une bielle (62b) agencée entre le moteur et le deuxième membre ou par une noix montée sur une vis agencée au deuxième membre.

15. Un système de positionnement d'un outil d'un véhicule aérien sans équipage (10) pouvant être monté relativement à une ligne électrique (12) pour surveiller un composant (11) de la ligne, le système de positionnement (50) comprenant: un module de déplacement (60) ayant un premier membre (62) montable à un côté d'un corps (20) du véhicule aérien sans équipage, un deuxième membre (64) déplaçable verticalement par rapport au premier membre sur le côté du corps, et un porte-outil (66) couplé pivotablement au deuxième membre et couplable à l'outil (30), le porte-outil (66) étant déplaçable relativement au corps (20) pour monter l'outil au composant (11) ou autour du composant.
